(19) Europäisches Patentamt
European Patent Office
Office européen des brevets

(11) **EP 4 752 570 A1**

(12) **EUROPEAN PATENT APPLICATION**
published in accordance with Art. 153(4) EPC

(43) Date of publication:
**03.06.2026 Bulletin 2026/23**

(21) Application number: **23950092.9**

(22) Date of filing: **29.08.2023**

(51) International Patent Classification (IPC):
**G01R 29/16** (2006.01)

(52) Cooperative Patent Classification (CPC):
**G01R 29/16**

(86) International application number:
**PCT/CN2023/115608**

(87) International publication number:
**WO 2025/043500 (06.03.2025 Gazette 2025/10)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Siemens Aktiengesellschaft**
**80333 München (DE)**

(72) Inventors:
• **WANG, Dan**
**Beijing 100102 (CN)**

• **LI, Jing**
**Beijing 100102 (CN)**
• **LIU, Hao**
**Beijing 100102 (CN)**
• **HUA, Wen Tao**
**Beijing 100102 (CN)**
• **ZHANG, Peng Fei**
**Beijing 100102 (CN)**
• **ZHAO, Shuang**
**Beijing 100102 (CN)**

(74) Representative: **Isarpatent**
**Patent- und Rechtsanwälte Part G mbB**
**Friedrichstrasse 31**
**80801 München (DE)**

(54) **MULTIPHASE CURRENT BALANCE STATE REPRESENTATION METHOD AND APPARATUS, ELECTRONIC DEVICE, AND STORAGE MEDIUM**

(57) A multiphase current balance state representation method and apparatus, an electronic device, and a storage medium. The method comprises: on the basis of each single-phase current value of each phase of a transformer corresponding to each detection point, obtaining each current difference value of each phase corresponding to each detection point (102); on the basis of each current difference value of each phase corresponding to each detection point, and a preset balance range, determining each balance state analysis label corresponding to each detection point (104); and matching each imbalance label of each phase with each balance state analysis label corresponding to each detection point to generate an imbalance state representation graph of the transformer corresponding to each imbalance label of each phase (106). According to the method, the imbalance state representation graph of the transformer corresponding to each imbalance label of each phase is generated, and each imbalance state of each phase is decomposed and displayed, so that the complex imbalance state of each phase in the transformer can be easily identified, improving the maintenance efficiency of a complex imbalance transformer.

**FIG. 1**

EP 4 752 570 A1

**Description**

**Technical Field**

The present application relates to the technical field of data processing, and in particular relates to a multi-phase current balance state representation method, apparatus, electronic device, storage medium, and computer program product.

**Background Art**

A distribution transformer is the main power supply equipment of a low-voltage power grid, and because low-voltage distribution systems mostly adopt a three-phase four-wire wiring mode, it is easy to cause a single-phase load imbalance problem. The current imbalance state of a three-phase transformer is mainly caused by such factors as unequal impedances of the distribution system, or different three-phase loads of the transformer. If a distribution transformer is in a three-phase unbalanced operating state for a long time, abnormal phenomena such as increased losses of the transformer and distribution lines, reduced active output of a motor, reduced transformer output, and damage to electrical equipment will be caused.

Current mainstream multi-phase current balance state analysis charts mainly present the balance state among multi-phase currents by plotting current value variation curves of the individual phases. However, variation curve analysis charts cannot give maintenance personnel an intuitive understanding of the imbalance cycle of each phase, and also cannot display the phase imbalance state in complex situations.

**Summary of the Invention**

In view of this, the multi-phase current balance state representation method, apparatus, electronic device, storage medium, and computer program product provided in the present application can be used to easily identify complex imbalance states of various phases of a transformer, and improve maintenance efficiency of a complex unbalanced transformer. According to a first aspect of embodiments of the present application, a multi-phase current balance state representation method is provided, comprising: obtaining, according to individual single-phase current values of each phase of a transformer corresponding to individual detection points, individual current difference values of each phase corresponding to the individual detection points; analyzing, according to the individual current difference values of each phase corresponding to the individual detection points and a preset balance range, a multi-phase current balance state of the individual detection points, and determining individual balance state analysis tags corresponding to the individual detection points, wherein each balance state analysis tag comprises one imbalance tag of one phase or one multi-phase balance tag; matching each imbalance tag of each phase with the individual balance state analysis tags corresponding to the individual detection points, to generate an imbalance state representation graph of each imbalance tag of each phase corresponding to the transformer.

According to a second aspect of embodiments of the present application, a multi-phase current balance state representation apparatus is provided, comprising: a calculation module, used to obtain, according to individual single-phase current values of each phase of a transformer corresponding to individual detection points, individual current difference values of each phase corresponding to the individual detection points; an analysis module, used to analyze, according to the individual current difference values of each phase corresponding to the individual detection points and a preset balance range, a multi-phase current balance state of the individual detection points, and determine individual balance state analysis tags corresponding to the individual detection points, wherein each balance state analysis tag is composed of one imbalance tag of one phase or one multi-phase balance tag; a generation module, used to match each imbalance tag of each phase with the individual balance state analysis tags corresponding to the individual detection points and generate an imbalance state representation graph of each imbalance tag of each phase corresponding to the transformer.

According to a third aspect of embodiments of the present application, an electronic device is provided, comprising: a processor, a memory, a communication interface, and a bus, wherein the processor, the memory, and the communication interface perform mutual communication through the bus; the memory is used to store at least one executable instruction, and the executable instruction causes the processor to perform operations corresponding to the multi-phase current balance state representation method described in the above first aspect.

According to a fourth aspect of embodiments of the present application, a computer-readable storage medium is provided, wherein computer instructions are stored on the computer-readable storage medium, and when the computer instructions are executed by a processor, the processor is caused to execute the multi-phase current balance state representation method described in the above first aspect.

According to a fifth aspect of embodiments of the present application, a computer program product is provided, comprising computer instructions, and the computer instructions instruct a computing device to perform operations corresponding to the method described in the first aspect.

It can be seen from the above technical solutions that the present application determines individual balance state analysis tags corresponding to individual detection points by analyzing the multi-phase current balance state of the individual detection points, and separately matches each imbalance tag of each phase with the individual balance state analysis tags corresponding to the individual detection points, so as to display each imbalance state of each phase in a decomposed manner. It is particularly suitable for displaying complex imbalance states of the various phases in a transformer, and can improve maintenance efficiency of a complex unbalanced transformer.

**Brief Description of the Drawings**

FIG. 1 is a flowchart of a multi-phase current balance state representation method of an exemplary embodiment of the present application.
FIG. 2 is a flowchart of a multi-phase current balance state representation method of another exemplary embodiment of the present application.
FIG. 3 is a flowchart of a multi-phase current balance state representation method of another exemplary embodiment of the present application.

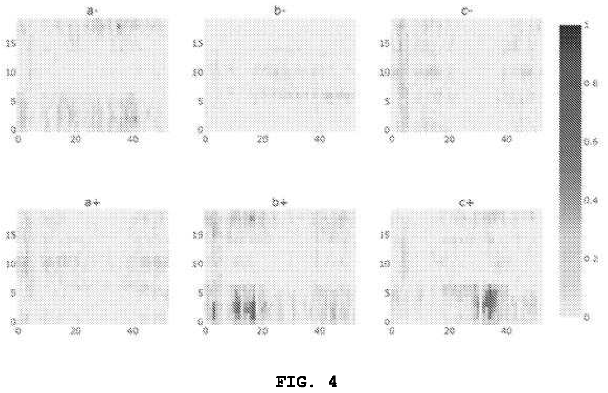

FIG. 4 exemplarily shows an imbalance state density map generated based on the method described in FIG. 3.
FIG. 5 is a schematic diagram of a multi-phase current balance state representation apparatus of an exemplary embodiment of the present application.
FIG. 6 is a schematic diagram of an electronic device of an exemplary embodiment of the present application.

List of Reference Numerals:

102: obtaining, according to individual single-phase current values of each phase of a transformer corresponding to individual detection points, individual current difference values of each phase corresponding to the individual detection points
104: analyzing, according to the individual current difference values of each phase corresponding to the individual detection points and a preset balance range, a multi-phase current balance state of the individual detection points, and determining individual balance state analysis tags corresponding to the individual detection points
106: matching each imbalance tag of each phase with the individual balance state analysis tags corresponding to the individual detection points and generating an imbalance state representation graph of each imbalance tag of each phase corresponding to the transformer
202: determining any one of the detection points as a current detection point
204: determining, according to a current difference value of each phase corresponding to the current detection point and the preset balance range, a phase whose current difference value does not fall within the preset balance range to be an unbalanced phase of the current detection point
206: identifying the unbalanced phase among the phases of the current detection point, and determining the balance state analysis tag of the current detection point
302: arranging, according to a detection date and a detection time of each detection point, the balance state analysis tags of each detection point, and generating a balance state analysis matrix of the transformer
304: determining one imbalance tag of any phase as a target tag
306: performing matching between the target tag and each imbalance state tag in the balance state analysis matrix, replacing each imbalance state tag matching the target tag with a matching tag, and replacing each imbalance state tag not matching the target tag with a non-matching tag
308: generating, according to each matching tag and each non-matching tag in the balance state analysis matrix, a matching matrix of the target tag
310: performing, by using a convolution window, convolution processing of each matching tag and each non-matching tag in the matching matrix of the target tag and generating an imbalance state density map of the transformer corresponding to the target tag

| 500: | multi-phase current balance state representation apparatus | 502: | calculation module | 504: | analysis module |
| 506: | generation module | 600: | electronic device | 602: | processor |

(continued)

| | | | | | |
|---|---|---|---|---|---|
| 604: | communication interface | 606: | memory | 608: | bus |
| 610: | program | | | | |

**Specific Embodiments**

In order to enable those skilled in the art to better understand the technical solutions in the embodiments of the present application, the technical solutions in the embodiments of the present application will be clearly and completely described below in conjunction with the drawings in the embodiments of the present application. Obviously, the described embodiments are only some of the embodiments of the present application, rather than all embodiments. All other embodiments obtained by those with ordinary skill in the art based on the embodiments of the present application should fall within the scope of protection of the embodiments of the present application.

Some embodiments of the present application are described in detail below in conjunction with the drawings. As long as there is no conflict among the embodiments, the following embodiments and features in the embodiments may be combined with each other. The steps in the following method embodiments are only used for exemplary description and are not used to limit the present invention.

A current imbalance state of a distribution transformer easily causes abnormal phenomena such as increased losses of the transformer and distribution lines, reduced active output of a motor, reduced transformer output, and damage to electrical equipment. Therefore, monitoring a phase load imbalance state of a transformer is crucial for maintaining optimal performance of equipment and ensuring safe operation of the equipment.

Current mainstream multi-phase current balance state analysis charts mainly present the balance state among multi-phase currents by plotting current value variation curves of the individual phases. However, variation curve analysis charts cannot give maintenance personnel an intuitive understanding of an imbalance cycle of each phase, and the visual effect of the analysis charts is not good. In addition, when the imbalance states of the individual phases in a transformer become complex, the operators also cannot accurately analyze such complex imbalance states through variation curve analysis charts, resulting in relatively great difficulties in current monitoring and maintenance work for complex imbalance states of transformers.

Based on the above problems, embodiments of the present application provide a multi-phase current balance state representation solution, which not only can improve visualization efficiency of imbalance states of the various phases in a transformer, so as to clearly display complex imbalance states of the various phases of the transformer, but also can improve maintenance and monitoring efficiency of a complex unbalanced transformer.

The multi-phase current balance state representation method, apparatus, electronic device, and storage medium provided in embodiments of the present application are described in detail below in conjunction with the drawings.

Multi-phase current balance state representation method

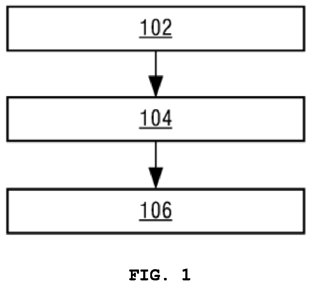

FIG. 1 is a flowchart of a multi-phase current balance state representation method of an exemplary embodiment of the present application. As shown in FIG. 1, the multi-phase current balance state representation method of this embodiment mainly comprises the following steps:

Step 102: obtaining, according to individual single-phase current values of each phase of a transformer corresponding to individual detection points, individual current difference values of each phase corresponding to the individual detection points.

In this embodiment, the transformer comprises a distribution transformer, for example, a three-phase transformer. However, the present invention is not limited thereto, and other types of multi-phase transformers are also applicable to the present application.

In some embodiments, based on a preset detection interval, a single-phase current of each phase of the transformer may be detected to obtain individual current detection values of each phase corresponding to individual detection points, and based on a preset value range, normalization processing may be performed on the individual current detection values of each phase corresponding to individual detection points to obtain individual single-phase current values of each phase corresponding to the individual detection points.

For example, taking a three-phase transformer as an example, when a preset detection interval is set to 15 minutes, a single-phase current of a first phase, a second phase, and a third phase corresponding to the three-phase transformer may be respectively detected every 15 minutes to obtain a first-phase current detection value, a second-phase current detection value, and a third-phase current detection value of the three-phase transformer corresponding to each detection point. According to a preset value range [0, 1], normalized data preprocessing may be performed on the first-phase current detection value, the second-phase current detection value, and the third-phase current detection value of the three-phase transformer corresponding to each detection point, so that the current detection values of each phase corresponding to individual detection points are limited to the value range from 0 to 1, and the single-phase current values (a first-phase current value, a second-phase current value, and a third-phase current value) of each phase corresponding to the individual detection points are obtained.

In some embodiments, current difference values of each phase corresponding to individual detection points may be obtained in the following way:

For any one current detection point among the detection points, according to a single-phase current value of each phase of the transformer corresponding to the current detection point, an averaged current value of the current detection point is obtained, and according to the single-phase current value of each phase corresponding to the current detection point and the averaged current value of the current detection point, calculation of the difference is performed, and a current difference value of each phase corresponding to the current detection point is obtained.

Specifically, summation and averaging calculation may be performed according to the single-phase current value of each phase of the transformer corresponding to the current detection point to obtain the averaged current value of the current detection point. By respectively performing calculation of the difference between each single-phase current value of the current detection point and the averaged current value of the current detection point, the current difference value of each phase corresponding to the current detection point (that is, a current difference between each phase of the current detection point and the averaged current value) is obtained.

In some embodiments, the current difference value of each phase corresponding to the current detection point may be calculated by using the following Formula 1:

$$k_{ij} = \left(x_{ij} - u_i\right)/u_i \qquad \text{(Formula 1)}$$

In the above Formula 1, $k_{ij}$ represents a current difference value of a $j$-th phase of the transformer corresponding to an $i$-th detection point, $x_{ij}$ represents a single-phase current value of the $j$-th phase of the transformer corresponding to the $i$-th detection point, and $u_i$ represents an averaged current value of the $i$-th detection point.

Step 104: analyzing, according to the current difference values of each phase corresponding to individual detection points and a preset balance range, the multi-phase current balance states of the individual detection points, and determining the balance state analysis tags corresponding to the individual detection points.

In this embodiment, each balance state analysis tag may be composed of one imbalance tag of one phase, or one multi-phase balance tag.

In some embodiments, it is possible to analyze each detection point for its unbalanced phase based on the current difference values of each phase corresponding to individual detection points and a preset balance range, and determine an imbalance tag of an unbalanced phase to be the balance state analysis tag of each detection point.

In some embodiments, each phase may comprise a first imbalance tag and a second imbalance tag, wherein the first imbalance tag is used to represent an imbalance state of excessively high current of each phase, and the second imbalance tag is used to represent an imbalance state of excessively low current of each phase.

In this embodiment, when a current value of each phase at a current detection point is within the normal range, a multi-phase balance tag may be determined as the balance state analysis tag of the current detection point.

Optionally, different tag values may be used to represent each imbalance tag of each phase and the multi-phase balance tag. For example, in an embodiment of a three-phase transformer, a tag value of a first imbalance tag of a first phase may be set to +1, and a tag value of a second imbalance tag of the first phase may be set to -1; a tag value of a first imbalance tag of a second phase may be set to +2, and a tag value of a second imbalance tag of the second phase may be set to -2; a tag value of a first imbalance tag of a third phase may be set to +3, and a tag value of a second imbalance tag of the third phase may be set to -3; and a tag value of the multi-phase balance tag may be set to 0.

In some embodiments, when a single-phase current value of each phase of the transformer corresponding to a current detection point is missing, for example, when a single-phase current value of each phase of the transformer corresponding to the current detection point is not detected, then a given data missing tag may be determined as the balance state analysis tag of the current detection point.

In some embodiments, a tag value of the data missing tag and a tag value of the multi-phase balance tag may be set to be the same or different. For example, the tag value of the data missing tag may also be set to 0, or the tag value of the data missing tag may be set to 99.

Step 106: matching each imbalance tag of each phase with individual balance state analysis tags corresponding to individual detection points to generate an imbalance state representation graph of each imbalance tag of each phase corresponding to the transformer.

Optionally, one imbalance tag of any phase may be determined as a target tag, matching of the target tag with each imbalance state tag in the balance state analysis matrix is performed, each imbalance state tag matching the target tag is replaced with a matching tag, each imbalance state tag not matching the target tag is replaced with a non-matching tag, and according to each matching tag and each non-matching tag in the balance state analysis matrix, an imbalance state representation graph of the transformer corresponding to the target tag is obtained.

For example, in an embodiment of a three-phase transformer, a first imbalance tag and a second imbalance tag of the three phases may be respectively used as target tags, and are respectively matched with individual balance state analysis tags corresponding to individual detection points, to generate 6 imbalance state representation graphs of the transformer, comprising: an imbalance state representation graph of the transformer corresponding to the first imbalance tag of the first phase (used to represent an imbalance state of excessively high current of the first phase); an imbalance state representation graph of the transformer corresponding to the second imbalance tag of the first phase (used to represent an imbalance state of excessively low current of the first phase); an imbalance state representation graph of the transformer corresponding to the first imbalance tag of the second phase (used to represent an imbalance state of excessively high current of the second phase); an imbalance state representation graph of the transformer corresponding to the second imbalance tag of the second phase (used to represent an imbalance state of excessively low current of the second phase); an imbalance state representation graph of the transformer corresponding to the first imbalance tag of the third phase (used to represent an imbalance state of excessively high current of the third phase); and an imbalance state representation graph of the transformer corresponding to the second imbalance tag of the third phase (used to represent an imbalance state of excessively low current of the third phase) .

Optionally, according to a detection date and a detection time of each detection point and the balance state analysis tag of each detection point, the matrix elements in a balance state analysis matrix may be filled to generate the balance state analysis matrix of the transformer, and matching is performed according to each imbalance state tag of each phase and each balance state analysis tag in the balance state analysis matrix, to generate an imbalance state representation graph of each imbalance tag of each phase corresponding to the transformer.

The multi-phase current balance state representation solution provided in embodiments of the present application can decompose and display imbalance states of different phases by respectively generating an imbalance state representation graph of each imbalance tag of each phase corresponding to the transformer, can be used to easily identify complex imbalance states of the various phases of the transformer, and improve maintenance efficiency of a complex unbalanced transformer. The multi-phase current balance state representation solution provided in embodiments of the present application respectively calculates averaged current values of individual detection points according to individual single-phase current values of each phase corresponding to the individual detection points, and dynamically calculates the current difference values of each phase corresponding to the individual detection points according to the averaged current values of the individual detection points, thereby improving the objectivity and accuracy of multi-phase current balance state analysis results.

The multi-phase current balance state representation solution provided in embodiments of the present application replaces each imbalance state tag with a matching tag or a non-matching tag according to a matching result between an imbalance state tag of a phase and each balance state analysis tag in a balance state analysis matrix, to generate a binarized imbalance state representation graph, which can effectively remove noise points in an image, make the image clearer and more intuitive, and improve visualization effect of the imbalance state representation graph.

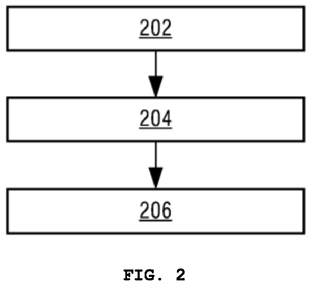

FIG. 2 is a processing flowchart of a multi-phase current balance state representation method of another exemplary embodiment of the present application. This embodiment shows a specific implementation of the above-described step 104. As shown in the figure, this embodiment mainly comprises:

Step 202: determining any one of the detection points as a current detection point.

For example, according to a chronological order of detection times of the detection points, one of the detection points may be sequentially determined as the current detection point. Step 204: determining, according to a current difference value of each phase corresponding to the current detection point and a preset balance range, a phase whose current difference value does not fall within the preset balance range as an unbalanced phase of the current detection point.

Optionally, the preset balance range may be set to [-0.4, +0.4]. If a current difference value of any phase corresponding to the current detection point is greater than +0.4 or less than -0.4, then any phase is determined as an unbalanced phase of the current detection point.

It should be noted that those skilled in the art may arbitrarily set a preset balance threshold based on factors such as actual analysis requirements and an application scenario of the transformer, and the present application is not limited thereto.

Step 206: identifying an unbalanced phase among the phases of the current detection point, and determining the balance state analysis tag of the current detection point.

In some embodiments, if the current detection point comprises only one unbalanced phase, then an imbalance tag of the unbalanced phase is determined as the balance state analysis tag of the current detection point.

In this embodiment, the current difference value of the unbalanced phase and the preset balance range may be compared; if the current difference value of the unbalanced phase is greater than the upper limit value of the preset balance range, the first imbalance tag of the unbalanced phase is determined as the balance state analysis tag of the current detection point; if the current difference value of the unbalanced phase is less than the lower limit value of the preset balance range, the second imbalance tag of the unbalanced phase is determined as the balance state analysis tag of the current detection point.

For example, if $k_{ij} > 0.4$ ($k_{ij}$ represents the current difference value of the j-th phase of the transformer corresponding to the *i*-th detection point), the first imbalance tag of the j-th phase (the unbalanced phase) is determined as the balance state analysis tag of the *i*-th detection point (the current detection point); if $k_{ij} < -0.4$, the second imbalance tag of the j-th phase (the unbalanced phase) is determined as the balance state analysis tag of the *i*-th detection point (the current detection point).

In some embodiments, if the current detection point comprises a plurality of unbalanced phases, the absolute values of the difference values of individual unbalanced phases corresponding to the current detection point are determined according to the current difference values corresponding to the individual unbalanced phases, and the imbalance tag of the unbalanced phase having the largest absolute value of the difference value is determined as the balance state analysis tag of the current detection point.

Taking a three-phase transformer as an example, in a case where a first phase and a second phase are both determined as unbalanced phases of the current detection point, if the current difference value of the first phase corresponding to the current detection point is -0.6 and the current difference value of the second phase corresponding to the current detection point is +0.5, it may be determined that the absolute value of the difference value of the first phase corresponding to the current detection point is 0.6, and the absolute value of the difference value of the second phase corresponding to the current detection point is 0.5. Here, because the absolute value of the difference value of the first phase is greater than the absolute value of the difference value of the second phase, and the current difference value of the first phase corresponding to the current detection point is less than the preset balance range, the second imbalance tag of the first phase may be determined as the balance state analysis tag of the current detection point.

In some embodiments, if the current detection point does not comprise an unbalanced phase, a preset multi-phase balance tag may be determined as the balance state analysis tag of the current detection point.

In this embodiment, different tag values may be used to represent each imbalance tag of each phase and the multi-phase balance tag.

For example, in an embodiment of a three-phase transformer, a tag value of a first imbalance tag of a first phase may be set to +1, and a tag value of a second imbalance tag of the first phase may be set to -1; a tag value of a first imbalance tag of a second phase may be set to +2, and a tag value of a second imbalance tag of the second phase may be set to -2; a tag value of a first imbalance tag of a third phase may be set to +3, and a tag value of a second imbalance tag of the third phase may be set to -3; and a tag value of the multi-phase balance tag may be set to 0. Therefore, the tag value of the balance state analysis tag of the current detection point should comprise one of "-1", "+1", "-2", "+2", "-3", "+3", and "0".

In some embodiments, the balance state analysis tag of the current detection point may further comprise a tag value of "99" for a data missing tag, used to represent a case where a single-phase current value of each phase of the transformer corresponding to the current detection point is missing.

The multi-phase current balance state representation solution provided in embodiments of the present application determines an unbalanced phase among phases of each detection point according to a preset balance range and the current difference value of each phase corresponding to each detection point, and performs a multi-dimensional analysis in combination with the absolute value of the difference value of the unbalanced phase and the current difference value, so as to perform detailed classification of complex current imbalance states of the detection points, which can help operators to easily identify complex situations of an unbalanced transformer according to the balance state analysis tags corresponding to the detection points, and improve maintenance efficiency of a complex transformer.

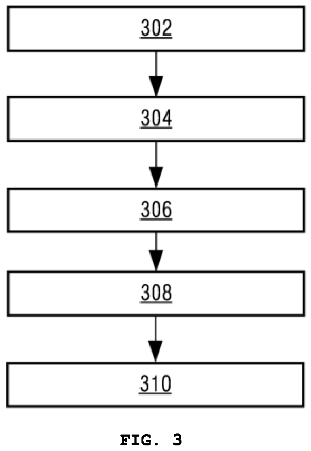

FIG. 3 is a processing flowchart of a multi-phase current balance state representation method of another exemplary embodiment of the present application. This embodiment shows a specific implementation of the above-described step 106. As shown in the figure, this embodiment mainly comprises:

Step 302: arranging, according to a detection date and a detection time of each detection point, the balance state analysis tag of each detection point, to generate a balance state analysis matrix of the transformer.

Optionally, the number of rows and the number of columns of the balance state analysis matrix may be determined according to the detection date and the detection time of each detection point.

Exemplarily, the number of columns of the balance state analysis matrix may be determined according to the detection date of the detection point. For example, if the detection time is 365 days, the number of columns of the balance state analysis matrix may be correspondingly set to 365 columns; the number of rows of the balance state analysis matrix is determined according to the detection interval of the detection point. For example, if the detection interval is set to 15 minutes, there should be 96 detection points per day, and the number of rows of the balance state analysis matrix may be correspondingly set to 96 rows.

Optionally, according to the detection date and the detection time of the detection point of each balance state analysis tag, each balance state analysis tag may be filled into each matrix element of the balance state analysis matrix, to generate a balance state analysis matrix of the transformer, by referring to Matrix 1 shown as follows:

$$\begin{bmatrix} 0 & 0 & 0 & \cdots & 99 & 0 & 2 \\ 1 & 0 & 0 & \cdots & 99 & 0 & 2 \\ -1 & 0 & 0 & \cdots & 99 & 0 & 2 \\ \cdots & \cdots & \cdots & \cdots & \cdots & \cdots & \cdots \\ 0 & 0 & 0 & \cdots & 99 & 0 & 0 \\ 0 & 0 & 0 & \cdots & 99 & 0 & 2 \\ 0 & 0 & 0 & \cdots & 99 & 2 & 0 \end{bmatrix}$$

Step 304: determining one imbalance tag of any phase as a target tag.

Optionally, according to each imbalance tag of each phase of the transformer, one imbalance tag of one phase may be sequentially determined as the target tag.

For example, a three-phase transformer comprises three phases, and each phase comprises a first imbalance tag and a second imbalance tag; therefore, one imbalance tag may be sequentially obtained from 6 imbalance tags of the three-phase transformer and be determined as the target tag.

Step 306: performing matching between the target tag and each imbalance state tag in the balance state analysis matrix, replacing each imbalance state tag matching the target tag with a matching tag, and replacing each imbalance state tag not matching the target tag with a non-matching tag.

For example, when the target tag is the first imbalance tag of the first phase of the three-phase transformer, according to an imbalance state tag of each matrix element in the balance state analysis matrix, a tag value of the target tag is matched with an element value of each matrix element. Here, for any one current matrix element among the matrix elements, if a tag value of the current matrix element is the same as the tag value of the target tag, the tag value (also known as the element value) of the current matrix element is replaced with the tag value of the matching tag; if the tag value of the current matrix element is not the same as the tag value of the target tag, the tag value of the current matrix element is replaced with the tag value of the non-matching tag.

In this embodiment, the tag value of the matching tag may be set to "1", and the tag value of the non-matching tag may be set to "0".

Step 308: generating, according to each matching tag and each non-matching tag in the balance state analysis matrix, a matching matrix of the target tags.

For example, in a case where the tag value of the matching tag is set to "1" and the tag value of the non-matching tag is set to "0", after performing matching between the balance state analysis matrix shown in the above-mentioned Matrix 1 and the target tag having a tag value of "+1", a binarized Matrix 2 shown as follows can be obtained:

$$\begin{bmatrix} 0 & 0 & 0 & \cdots & 0 & 0 & 0 \\ 1 & 0 & 0 & \cdots & 0 & 0 & 0 \\ 0 & 0 & 0 & \cdots & 0 & 0 & 0 \\ \cdots & \cdots & \cdots & \cdots & \cdots & \cdots & \cdots \\ 0 & 0 & 0 & \cdots & 0 & 0 & 0 \\ 0 & 0 & 0 & \cdots & 0 & 0 & 0 \\ 0 & 0 & 0 & \cdots & 0 & 0 & 0 \end{bmatrix}$$

Step 310: performing, by using a convolution window, convolution processing of each matching tag and each non-matching tag in the matching matrix of the target tag, to generate an imbalance state density map of the transformer corresponding to the target tag.

Optionally, sliding processing satisfying a preset sliding step size may be repeatedly performed on the matching matrix by using the convolution window, to determine a submatrix corresponding to each sliding processing of the matching matrix, and convolution operation is performed, by using convolution parameters in the convolution window, on at least one matching tag and/or at least one non-matching tag in each submatrix, to obtain at least one convolution value in each submatrix; each convolution value in the matching matrix is obtained according to each convolution value in each submatrix, and an imbalance state density map of the transformer corresponding to the target tag is generated according to each convolution value in the matching matrix. Exemplarily, in an embodiment of a three-phase transformer, 6 imbalance state density maps of the transformer may be generated according to 6 balance state analysis tags of the three-phase transformer. Here, an "a-" map means that current in phase a of the three-phase transformer is lower than the preset balance range, an "a+" map means that current in phase a of the three-phase transformer is higher than the preset balance range, a "b-" map means that current in phase b of the three-phase transformer is lower than the preset balance range, a "b+" map means that current in phase b of the three-phase transformer is higher than the preset balance range, a "c-" map means that current in phase c of the three-phase transformer is lower than the preset balance range, and a "c+" map means that current in phase c of the three-phase transformer is higher than the preset balance range. In addition, color depth in each map is used to display a possibility of phase imbalance, and a darker color means a higher probability of phase imbalance.

In some embodiments, the window size of the convolution window may be set to $4 \times 5$, and the convolution parameters in the convolution window are all set to 0.5.

It should be noted that those skilled in the art may arbitrarily adjust the window size, the sliding step size, and the convolution parameters of the convolution window based on factors such as data noise of original data, display effect requirements of the imbalance state representation graph, and performance requirements of the processing system, and the present application is not limited thereto.

The multi-phase current balance state representation solution provided in embodiments of the present application determines one target tag from the imbalance tags of the phases, respectively performs matching between each target tag and each imbalance state tag in the balance state analysis matrix to generate an imbalance state representation graph of the transformer corresponding to each target tag, and by a technical means of decomposing and displaying each imbalance state of each phase, can be used to easily identify a complex imbalance situation of the transformer, and improve the maintenance effect of a complex unbalanced transformer.

The multi-phase current balance state representation solution provided in embodiments of the present application performs smoothing processing on each element value in the matching matrix by using a preset convolution window, to generate an imbalance state density map of the transformer corresponding to the target tag, thereby improving visualization effect of the analysis map.

Multi-phase current balance state representation apparatus

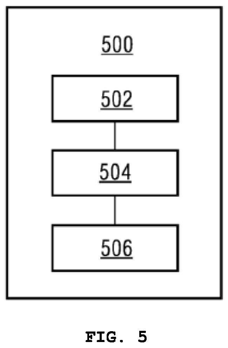

Corresponding to the above method embodiments, FIG. 5 shows a schematic diagram of a multi-phase current balance state representation apparatus of an embodiment of the present application. As shown in FIG. 5, the multi-phase current balance state representation apparatus 500 comprises:

a calculation module 502, used to obtain, according to the single-phase current values of each phase of a transformer corresponding to the detection points, the current difference values of each phase corresponding to the detection points;

an analysis module 504, used to analyze, according to the current difference values of each phase corresponding to the detection points and a preset balance range, multi-phase current balance states of the detection points, and determine the balance state analysis tags corresponding to the detection points, wherein each balance state analysis tag is composed of one imbalance tag of one phase or one multi-phase balance tag;

a generation module 506, used to match each imbalance tag of each phase with the balance state analysis tags corresponding to the detection points, to generate an imbalance state representation graph of each imbalance tag of the transformer corresponding to each phase.

Optionally, the calculation module 502 is further used to, for any one current detection point among the detection points: obtain, according to the single-phase current value of each phase of the transformer corresponding to the current detection point, the averaged current value of the current detection point; and perform difference calculations according to the single-phase current value of each phase corresponding to the current detection point and the averaged current value of the current detection point, to obtain the current difference value of each phase corresponding to the current detection point.

Optionally, the analysis module 504 is further used to, for any one current detection point among the detection points: determine, according to the current difference value of each phase corresponding to the current detection point and the preset balance range, a phase whose current difference value does not fall within the preset balance range as an unbalanced phase of the current detection point; identify an unbalanced phase among the phases of the current detection point, and if the current detection point comprises one unbalanced phase, determine one imbalance tag of the unbalanced phase as the balance state analysis tag of the current detection point; if the current detection point comprises a plurality of unbalanced phases, determine, according to the current difference values of the unbalanced phases corresponding to the current detection point, the absolute values of the difference values of the unbalanced phases corresponding to the current detection point, and determine the one imbalance tag of the unbalanced phase having the largest absolute value of the difference value as the balance state analysis tag of the current detection point; if the current detection point does not comprise an unbalanced phase, determine the multi-phase balance tag as the balance state analysis tag of the current detection point.

Optionally, each phase comprises a first imbalance tag and a second imbalance tag.

Optionally, in a case where one imbalance tag of an unbalanced phase is determined as the balance state analysis tag of the current detection point, the analysis module 504 is further used to compare the current difference value of the unbalanced phase with the preset balance range; if the current difference value of the unbalanced phase is greater than the upper limit value of the preset balance range, determine the first imbalance tag of the unbalanced phase as the balance state analysis tag of the current detection point; if the current difference value of the unbalanced phase is less than the lower limit value of the preset balance range, determine the second imbalance tag of the unbalanced phase as the balance state analysis tag of the current detection point.

Optionally, the generation module 506 is further used to arrange, according to a detection date and a detection time of each detection point, the balance state analysis tag of each detection point, to generate a balance state analysis matrix of the transformer; and perform matching according to each imbalance state tag of each phase and each balance state analysis tag in the balance state analysis matrix, to generate an imbalance state representation graph of each imbalance tag of the transformer corresponding to each phase.

Optionally, the generation module 506 is further used to determine one imbalance tag of any phase as a target tag; perform matching between the target tag and each imbalance state tag in the balance state analysis matrix, replace each imbalance state tag matching the target tag with a matching tag, and replace each imbalance state tag not matching the target tag with a non-matching tag; and obtain, according to each matching tag and each non-matching tag in the balance state analysis matrix, an imbalance state representation graph of the transformer corresponding to the target tag. Optionally, the imbalance state representation graph comprises an imbalance state density map.

Optionally, the generation module 506 is further used to generate, according to each matching tag and each non-matching tag in the balance state analysis matrix, a matching matrix of the target tag; perform, by using a convolution window, convolution processing of each matching tag and each non-matching tag in the matching matrix, to generate an imbalance state density map of the transformer corresponding to the target tag.

Optionally, the generation module 506 is further used to repeatedly perform, by using the convolution window, sliding processing satisfying a preset sliding step size on the matching matrix, to determine a submatrix corresponding to each sliding processing of the matching matrix; perform, by using convolution parameters in the convolution window, convolution operation for at least one matching tag and/or at least one non-matching tag of each submatrix, to obtain each convolution value of each submatrix; obtain each convolution value of the matching matrix according to each convolution value of each submatrix; and generate, according to each convolution value of the matching matrix, an imbalance state density map of the transformer corresponding to the target tag.

Optionally, the transformer comprises a three-phase transformer.

It should be noted that as the contents such as information interaction among the units in the above-described multi-phase current balance state representation apparatus and the execution process are based on the same concept as the previously described embodiments of the multi-phase current balance state representation method, reference may be made to the descriptions in the previously described embodiments of the multi-phase current balance state representation method for these specific contents, and they are not repeated herein.

Electronic device

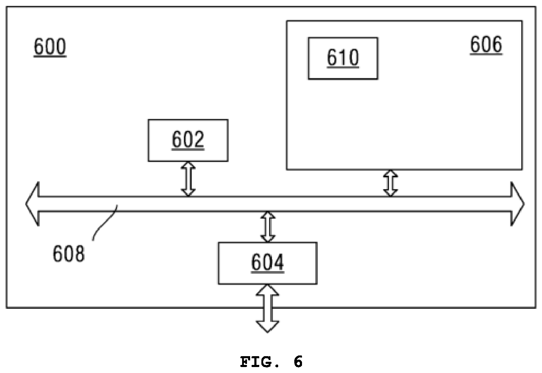

FIG. 6 is a schematic diagram of an electronic device provided in Embodiment 4 of the present application, and specific embodiments of the present application do not limit a specific implementation of the electronic device. Referring to FIG. 6, the electronic device 600 provided in embodiments of the present application comprises: a processor (processor) 602, a communications interface (Communications Interface) 604, a memory (memory) 606, and a bus 608. Wherein: The processor 602, the communications interface 604, and the memory 606 perform mutual communication through the bus 608.

The communications interface 604 is used to communicate with other electronic devices or servers.

The processor 602 is used to execute a program 610, and specifically may execute related steps in the above embodiments of the multi-phase current balance state representation method.

Specifically, the program 610 may comprise program code, and the program code comprises computer operation instructions.

The processor 602 may be a central processing unit (CPU), or an application specific integrated circuit (ASIC) (Application Specific Integrated Circuit), or one or more integrated circuits used to implement embodiments of the present application. One or more processors included in a smart device may be processors of the same type, such as one or more CPUs; or may be processors of different types, such as one or more CPUs and one or more ASICs.

The memory 606 is used to store the program 610. The memory 606 may comprise a high-speed RAM memory, and may also comprise a non-volatile memory (non-volatile memory), such as at least one disk memory.

The program 610 may specifically be used to cause the processor 602 to execute the multi-phase current balance state representation method in any of the above-described embodiments.

For specific implementations of steps in the program 610, reference may be made to corresponding descriptions in corresponding steps and units in the above-described embodiments of the multi-phase current balance state representation method, and they are not described again herein. Those skilled in the art can clearly understand that, for convenience and conciseness of description, for specific working processes of the devices and modules described above, reference may be made to corresponding process descriptions in the foregoing method embodiments, and they are not described again herein.

Computer-readable storage medium

The present application further provides a computer-readable storage medium storing instructions for causing a machine to execute the multi-phase current balance state representation method as described herein. Specifically, a system or an apparatus equipped with a storage medium may be provided, software program code for implementing functions of any of the above-described embodiments is stored on the storage medium, and a computer (or a CPU or an MPU) of the system or the apparatus reads out and executes the program code stored in the storage medium.

In this case, the program code read from the storage medium itself can implement functions of any of the above-described embodiments, and therefore the program code and the storage medium storing the program code constitute a part of the present application.

Storage medium embodiments for providing the program code comprise a floppy disk, a hard disk, a magneto-optical disk, an optical disk (such as CD-ROM, CD-R, CD-RW, DVD-ROM, DVD-RAM, DVD-RW, DVD+RW), a magnetic tape, a non-volatile memory card, and a ROM. Optionally, the program code may be downloaded from a server computer via a communications network.

Computer program product

Embodiments of the present application further provide a computer program product, comprising computer instructions, and the computer instructions instruct a computing device to perform corresponding operations in any of the above-described method embodiments.

It should be noted that, according to implementation needs, each part/step described in embodiments of the present application may be split into more parts/steps, and two or more parts/steps or partial operations of parts/steps may also be combined into new parts/steps, so as to achieve objectives of embodiments of the present application.

The above-described methods according to embodiments of the present application may be implemented in hardware or firmware, or be implemented as software or computer code that can be stored in a recording medium (such as a CD ROM, a RAM, a floppy disk, a hard disk, or a magneto-optical disk), or be implemented as computer code originally stored in a remote recording medium or a non-transitory machine-readable medium and downloaded via a network and be stored in a local recording medium, such that the methods described herein may be stored as such software processing on a recording medium using a general-purpose computer, a dedicated processor, or programmable or dedicated hardware (such as an ASIC or an FPGA). It can be understood that a computer, a processor, a microprocessor controller, or programmable hardware comprises a storage component (for example, RAM, ROM, flash memory, and the like) capable of storing or receiving software or computer code, and when the software or computer code is accessed and executed by the computer, processor, or hardware, the methods described herein are implemented. In addition, when a general-purpose computer accesses code for implementing the methods shown herein, execution of the code converts the general-purpose computer into a special-purpose computer for performing the methods shown herein.

It should be noted that not all steps and modules in the above flows and system structural diagrams are necessary, and some steps or modules may be omitted according to actual needs. The execution order of the steps is not fixed, and may be adjusted as needed. The system structures described in the above embodiments may be physical structures or logical structures, that is, some modules may be implemented by the same physical entity, or some modules may be implemented separately by a plurality of physical entities, or may be jointly implemented by some components in a plurality of independent devices.

In this patent application, nouns and pronouns relating to persons are not limited to a specific gender.

In the above embodiments, a hardware module may be implemented in a mechanical manner or an electrical manner. For example, a hardware module may comprise a permanent dedicated circuit or logic (such as a dedicated processor, an FPGA, or an ASIC) to perform corresponding operations. The hardware module may also comprise programmable logic or a circuit (such as a general-purpose processor or another programmable processor), which may be temporarily configured by software to perform corresponding operations. A specific implementation manner (a mechanical manner, or a dedicated permanent circuit, or a temporarily configured circuit) may be determined based on cost and time considerations.

The present invention has been shown and described in detail herein through the drawings and preferred embodiments, but the present invention is not limited to these disclosed embodiments, and based on the above-described embodiments, those skilled in the art can know that more embodiments of the present invention can be obtained by combining code review means in the above-described different embodiments, and these embodiments are also within the scope of protection of the present invention.

In this patent application, nouns and pronouns relating to persons are not limited to a specific gender.

**Claims**

1. A multi-phase current balance state representation method, comprising:

   obtaining, according to individual single-phase current values of each phase of a transformer corresponding to individual detection points, individual current difference values of each phase corresponding to the individual detection points (102);
   analyzing, according to the individual current difference values of each phase corresponding to the individual detection points and a preset balance range, a multi-phase current balance state of individual detection points, and determining individual balance state analysis tags corresponding to the individual detection points, wherein each balance state analysis tag comprises one imbalance tag of one phase or one multi-phase balance tag (104);
   matching each imbalance tag of each phase with the individual balance state analysis tags corresponding to the individual detection points, to generate an imbalance state representation graph of each imbalance tag of the transformer corresponding to each phase (106).

2. The method according to claim 1, wherein obtaining, according to the single-phase current values of each phase of the transformer corresponding to the individual detection points, individual current difference values of each phase corresponding to the individual detection points comprises:

   for any one current detection point among the detection points;
   obtaining, according to the single-phase current values of each phase of the transformer corresponding to the current detection point, an averaged current value of the current detection point;
   performing difference calculation according to the single-phase current value of each phase corresponding to the current detection point and the averaged current value of the current detection point, to obtain a current difference value of each phase corresponding to the current detection point.

3. The method according to claim 1, wherein analyzing, according to the current difference values of each phase corresponding to the individual detection points and a preset balance range, multi-phase current balance states of the individual detection points, and determining balance state analysis tags corresponding to the individual detection points comprises:

   for any one current detection point among the detection points;
   determining, according to the current difference value of each phase corresponding to the current detection point and the preset balance range, a phase whose current difference value does not fall within the preset balance range as an unbalanced phase of the current detection point;
   identifying an unbalanced phase among the phases of the current detection point,
   if the current detection point comprises one unbalanced phase, determining one imbalance tag of the unbalanced phase as the balance state analysis tag of the current detection point;
   if the current detection point comprises a plurality of unbalanced phases, determining, according to the current difference values of the individual unbalanced phases corresponding to the current detection point, absolute values of difference values of the individual unbalanced phases corresponding to the current detection point, and determining one imbalance tag of an unbalanced phase having a largest absolute value of the difference value as the balance state analysis tag of the current detection point;
   if the current detection point does not comprise an unbalanced phase, determining the multi-phase balance tag as the balance state analysis tag of the current detection point.

4. The method according to claim 3, wherein each phase comprises a first imbalance tag and a second imbalance tag; and wherein, in a case where one imbalance tag of an unbalanced phase is determined as the balance state analysis tag of the current detection point, the method further comprises:

   comparing the current difference value of the unbalanced phase with the preset balance range,
   if the current difference value of the unbalanced phase is greater than an upper limit value of the preset balance range, determining the first imbalance tag of the unbalanced phase as the balance state analysis tag of the current detection point;

if the current difference value of the unbalanced phase is less than a lower limit value of the preset balance range, determining the second imbalance tag of the unbalanced phase as the balance state analysis tag of the current detection point.

5. The method according to any one of claims 1, 3, and 4, wherein matching each imbalance tag of each phase with the individual balance state analysis tags corresponding to the individual detection points to generate an imbalance state representation graph of each imbalance tag of the transformer corresponding to each phase comprises:

arranging, according to a detection date and a detection time of each detection point, the balance state analysis tag of each detection point, to generate a balance state analysis matrix of the transformer;

performing matching according to each imbalance state tag of each phase and each balance state analysis tag in the balance state analysis matrix to generate an imbalance state representation graph of each imbalance tag of the transformer corresponding to each phase.

6. The method according to claim 5, wherein performing matching according to each imbalance state tag of each phase and each balance state analysis tag in the balance state analysis matrix to generate an imbalance state representation graph of each imbalance tag of the transformer corresponding to each phase comprises:

determining one imbalance tag of any phase as a target tag;

performing matching between the target tag and each imbalance state tag in the balance state analysis matrix, replacing each imbalance state tag matching the target tag with a matching tag, and replacing each imbalance state tag not matching the target tag with a non-matching tag;

obtaining, according to each matching tag and each non-matching tag in the balance state analysis matrix, an imbalance state representation graph of the transformer corresponding to the target tag.

7. The method according to claim 6, wherein the imbalance state representation graph comprises an imbalance state density map;

and wherein obtaining, according to each matching tag and each non-matching tag in the balance state analysis matrix, an imbalance state representation graph of the transformer corresponding to the target tag comprises:

generating, according to each matching tag and each non-matching tag in the balance state analysis matrix, a matching matrix of the target tag;

performing, by using a convolution window, convolution processing on each matching tag and each non-matching tag in the matching matrix to generate an imbalance state density map of the transformer corresponding to the target tag.

8. The method according to claim 7, wherein performing, by using a convolution window, convolution processing on each matching tag and each non-matching tag in the matching matrix to generate an imbalance state density map of the transformer corresponding to the target tag comprises:

repeatedly performing, by using the convolution window, sliding processing satisfying a preset sliding step size on the matching matrix to determine a submatrix corresponding to each sliding processing of the matching matrix;

performing, by using convolution parameters in the convolution window, convolution operation on at least one matching tag and/or at least one non-matching tag of each submatrix, to obtain each convolution value of each submatrix;

obtaining each convolution value of the matching matrix according to each convolution value of each submatrix;

generating, according to each convolution value of the matching matrix, an imbalance state density map of the transformer corresponding to the target tag.

9. The method according to claim 1, wherein the transformer comprises a three-phase transformer.

10. A multi-phase current balance state representation apparatus (500), comprising:

a calculation module (502), used to obtain, according to individual single-phase current values of each phase of a transformer corresponding to individual detection points, individual current difference values of each phase corresponding to the individual detection points;

an analysis module (504), used to analyze, according to the individual current difference values of each phase corresponding to the individual detection points and a preset balance range, multi-phase current balance states of the individual detection points, and determine individual balance state analysis tags corresponding to the individual detection points, wherein each balance state analysis tag is composed of one imbalance tag of one phase or one multi-phase balance tag;

a generation module (506), used to match the individual imbalance tags of each phase with the individual balance state analysis tags corresponding to the individual detection points to generate an imbalance state representation graph of each imbalance tag of the transformer corresponding to each phase.

11. An electronic device (600), comprising: a processor (602), a communication interface (604), a memory (606), and a bus (608), wherein the processor (602), the communication interface (604), and the memory (606) perform mutual communication through the bus (608);

the memory (606) is used to store at least one executable instruction, and the executable instruction causes the processor (602) to perform operations corresponding to the method according to any one of claims 1 to 9.

12. A computer-readable storage medium, wherein computer instructions are stored on the computer-readable storage medium, and when the computer instructions are executed by a processor, the processor is caused to execute the method according to any one of claims 1 to 9.

13. A computer program product, comprising computer instructions, and the computer instructions instruct a computing device to perform operations corresponding to the method according to any one of claims 1 to 9.

```
┌─────────────────────────────┐
│             102             │
└─────────────────────────────┘
               │
               ▼
┌─────────────────────────────┐
│             104             │
└─────────────────────────────┘
               │
               ▼
┌─────────────────────────────┐
│             106             │
└─────────────────────────────┘
```

FIG. 1

FIG. 2

FIG. 3

FIG. 4

500

502

504

506

FIG. 5

**FIG. 6**

## INTERNATIONAL SEARCH REPORT

| International application No. |
|---|
| **PCT/CN2023/115608** |

### A. CLASSIFICATION OF SUBJECT MATTER

G01R 29/16(2006.01)i

According to International Patent Classification (IPC) or to both national classification and IPC

### B. FIELDS SEARCHED

Minimum documentation searched (classification system followed by classification symbols)

IPC：G01R

Documentation searched other than minimum documentation to the extent that such documents are included in the fields searched

Electronic data base consulted during the international search (name of data base and, where practicable, search terms used)

CNTXT: CNKI; ENTXTC; ENTXT: 变压器, 三相, 多相, 电流, 差, 平均, 均值, 不平衡, 不对称, 不均衡, 标签, 标记, 标志, 记号, 指示符, transformer, three phase? , multiphase, current, difference, average, mark, sign, indicator

### C. DOCUMENTS CONSIDERED TO BE RELEVANT

| Category* | Citation of document, with indication, where appropriate, of the relevant passages | Relevant to claim No. |
|---|---|---|
| X | CN 114759582 A (BEIJING SMARTCHIP MICROELECTRONICS TECHNOLOGY CO., LTD. et al.) 15 July 2022 (2022-07-15) <br> claims 1-8 | 1-4, 9-13 |
| A | CN 101055283 A (ZIBO ZHUO'ER ELECTRICAL EQUIPMENT CO.,LTD.) 17 October 2007 (2007-10-17) <br> entire document | 1-13 |
| A | CN 108631443 A (FOSHAN TRAVEL FROG TECHNOLOGY CO., LTD.) 09 October 2018 (2018-10-09) <br> entire document | 1-13 |
| A | CN 113452043 A (ZHANJIANG POWER SUPPLY BUREAU OF GUANGDONG POWER GRID CO., LTD.) 28 September 2021 (2021-09-28) <br> entire document | 1-13 |
| A | CN 115343543 A (CHINA SOUTHERN POWER GRID DIGITAL POWER GRID RESEARCH INSTITUTE CO., LTD.) 15 November 2022 (2022-11-15) <br> entire document | 1-13 |

☑ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **24 May 2024** | **25 May 2024** |

| Name and mailing address of the ISA/CN | Authorized officer |
|---|---|
| **China National Intellectual Property Administration (ISA/ CN)** <br> **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
|---|
| **PCT/CN2023/115608** |

**C.    DOCUMENTS CONSIDERED TO BE RELEVANT**

| Category* | Citation of document, with indication, where appropriate, of the relevant passages | Relevant to claim No. |
|---|---|---|
| A | CN 116014763 A (GUANGDONG POWER GRID COMPANY et al.) 25 April 2023 (2023-04-25)<br>    entire document | 1-13 |
| A | JP H03157711 A (HITACHI, LTD.) 05 July 1991 (1991-07-05)<br>    entire document | 1-13 |
| A | US 2005093376 A1 (SERVER TECHNOLOGY, INC.) 05 May 2005 (2005-05-05)<br>    entire document | 1-13 |
| A | US 5058031 A (AMERICAN STANDARD INC.) 15 October 1991 (1991-10-15)<br>    entire document | 1-13 |

Form PCT/ISA/210 (second sheet) (July 2022)

### INTERNATIONAL SEARCH REPORT
#### Information on patent family members

International application No.

**PCT/CN2023/115608**

| Patent document cited in search report | | | Publication date (day/month/year) | Patent family member(s) | | | Publication date (day/month/year) |
|---|---|---|---|---|---|---|---|
| CN | 114759582 | A | 15 July 2022 | None | | | |
| CN | 101055283 | A | 17 October 2007 | None | | | |
| CN | 108631443 | A | 09 October 2018 | None | | | |
| CN | 113452043 | A | 28 September 2021 | None | | | |
| CN | 115343543 | A | 15 November 2022 | None | | | |
| CN | 116014763 | A | 25 April 2023 | None | | | |
| JP | H03157711 | A | 05 July 1991 | JP | 2802523 | B2 | 24 September 1998 |
| US | 2005093376 | A1 | 05 May 2005 | US | 2016134111 | A1 | 12 May 2016 |
| | | | | US | 2012007423 | A1 | 12 January 2012 |
| | | | | US | 8541906 | B2 | 24 September 2013 |
| | | | | US | 2009051220 | A1 | 26 February 2009 |
| | | | | US | 7777365 | B2 | 17 August 2010 |
| | | | | US | 2014015317 | A1 | 16 January 2014 |
| | | | | US | 9190842 | B2 | 17 November 2015 |
| | | | | US | 2010302753 | A1 | 02 December 2010 |
| | | | | US | 7977815 | B2 | 12 July 2011 |
| | | | | US | 7414329 | B2 | 19 August 2008 |
| | | | | US | 2012212211 | A1 | 23 August 2012 |
| | | | | US | 8541907 | B2 | 24 September 2013 |
| US | 5058031 | A | 15 October 1991 | CA | 2036699 | A1 | 01 October 1991 |
| | | | | CA | 2036699 | C | 31 May 1994 |

Form PCT/ISA/210 (patent family annex) (July 2022)